# EUROPEAN PATENT SPECIFICATION

(11) **EP 3 188 580 B1**
(45) Date of publication and mention of the grant of the patent: **25.09.2019**
(21) Application number: 15836815.9
(22) Date of filing: 24.08.2015
(51) Int. Cl.: H05K 7/20, H01L 23/473, C09K 5/10

(54) **SYSTEM FOR COOLING ELECTRONIC EQUIPMENT**
SYSTEM ZUR KÜHLUNG VON ELEKTRONISCHER AUSRÜSTUNG
SYSTÈME DE REFROIDISSEMENT D'ÉQUIPEMENT ÉLECTRONIQUE

(30) Priority: 25.08.2014 JP 2014170616
(43) Date of publication of application: 05.07.2017
(73) Proprietor: Exascaler Inc., Tokyo 101-0052 (JP)
(72) Inventor: SAITO, Motoaki, Tokyo 101-0052 (JP)
(74) Representative: Goddar, Heinz J.
(86) International application number: PCT/JP2015/073757
(87) International publication number: WO 2016/031781

(56) References cited:
- EP-A2- 1 748 688
- WO-A1-90/03357
- JP-A- H1 168 369
- JP-A- H1 168 369
- JP-A- S6 465 185
- JP-A- H04 226 057
- JP-A- H04 226 057
- JP-A- S61 225 899
- JP-A- 2009 027 051
- US-A- 4 302 793

## Description

### Technical Field

The present invention relates to a cooling system for electronic equipment. Particularly, the invention relates to a system for efficiently cooling electronic equipment such as supercomputer or electronic equipment at a data center which is required of ultrahigh performance operation and generates a large amount of heat per se.

Document JPH1168369 A discloses a cooling device which is able to cool electric equipment having different losses and can be installed in a small space. Insulating oil cooled in a heat exchanger cools electric devices as the oil flows through two different through holes of partition plates provided below the devices. Of the two through holes, the hole below the device having the larger loss has a smaller diameter and the other hole below the device having the smaller loss has a larger diameter. Therefore, the device having the larger loss can be cooled more effectively and even the device having the smaller loss can be cooled efficiently, because the flow velocity of the oil in the smaller hole becomes faster and the heat transferring quantity of the oil becomes larger as the flow velocity increases.

Document US4302793 discloses a chassis filled with oil which accommodates a plurality of electronic components. The oil is circulated in order to cool the electronic components and the tank is accessible by opening a lid for maintenance.

### Background Art

One of the largest issues deciding the performance limit of recent supercomputers is power consumption. The importance of studies concerning thrifty power consumption of the supercomputer has already received wide recognition. Namely, speed performance per unit power consumption (Flops/W) is regarded as one evaluation index of supercomputer. It is reported that about 45 % of the total power consumption of the data center is consumed for cooling. There is a growing demand for reducing the power consumption by increasing cooling efficiency.

Conventionally, an air cooling system and a liquid cooling system are used for cooling the supercomputers or the data centers. The liquid cooling system is generally evaluated as having excellent cooling efficiency because of the use of a liquid having much higher heat transfer performance than air. For example, "TSUBAME-KFC", a supercomputer constructed by Tokyo Institute of Technology has achieved 4.50 GFlos/W by virtue of a liquid immersion cooling system employing synthetic oil. This supercomputer has attained first place for high speed performance per unit power consumption in the November 2013 issue and the June 2014 issue of "Supercomputer Green 500 List". However, a synthetic oil having high viscosity is used as a liquid coolant and hence, it is quite difficult to completely remove the adherent oil from electronic devices extracted from an oil immersion rack. This leads to an extremely complicated maintenance work for the electronic devices (specifically, adjustment, inspection, repair, part replacement, and expansion. The same applies hereinafter.) . Further, it is reported that the synthetic oil used in the cooling system may leak as corroding packing and the like constituting the cooling system in the short term, so as to adversely affect the operation of the cooling system.

On the other hand, a liquid immersion cooling system has been proposed which employs a fluorocarbon-based liquid coolant instead of the synthetic oil causing above-described problem. Specifically, this cooling system exemplifies a case where a hydrofluoroether (HFE) compound commercially available from 3M Limited as "Novec (trade name of 3M Limited, the same applying hereafter) 7100", "Novec 7200" or "Novec 7300" is used as the fluorocarbon-based liquid coolant (see for example, Patent Literature 1, Patent Literature 2).

### Citation List

### Patent Literature

PTL 1: Japanese Patent Application Laid-Open No. 2013-187251
PTL 2: Japanese Patent Application Laid-Open No. 2012-527109

### Summary of Invention

### Technical Problem

A cooling system disclosed in Patent Literature 1 employs a fluorocarbon-based liquid coolant having a boiling point of 100 °C or less because the system utilizes vaporization heat (latent heat) for cooling the electronic equipment. When the liquid coolant is vaporized by heat generated by devices mounted in the electronic equipment, the vaporization takes heat (vaporization heat (latent heat)) from the devices which in turn are cooled. Accordingly, the fluorocarbon-based liquid coolant may locally boil on the surface of a high-temperature device, producing air bubbles which form an insulation film. Hence, an excellent heat transfer capacity intrinsic to the liquid coolant may be impaired. The electronic devices used in the recent supercomputers, data centers and the like include a variety of objects to be cooled which include not only CPUs (Central Processing Unit) but also GPUs (Graphic Processing Unit), high-speed memories, chip sets, network units, bus switch units, SSDs (Solid State Drive) and the like. It is impracticable to equally cool all these cooling objects having different vaporizing temperatures. As for a cooling object on which the coolant is not vaporized, the cooling efficiency is extremely low.

In addition, the fluorocarbon-based liquid coolant having the boiling point of 100 °C or less is readily vaporized. This dictates the need for frequently replenishing the liquid coolant in the cooling system. Since the fluorocarbon-based liquid coolant is quite expensive in general, a maintenance cost for compensating for the evaporative loss of the liquid coolant is enormous. That is, a problem exists that the replenishment takes much time and labor.

The cooling system disclosed in Patent Literature 2 adopts a sealed module structure containing one or more heat generating electronic devices. Therefore, the whole mechanism for circulating the liquid coolant through the individual sealed modules is complicated. In addition, this cooling system is inferior in maintainability for the electronic device because it is not easy to extract the whole body of the electronic device from the sealed module.

It is therefore an object of the invention to solve the above-described problems of the prior art and to provide a cooling system which is adapted for notable reduction of the evaporative loss of liquid coolant and for efficient cooling of a plurality of electronic devices densely accommodated in a cooling bath of a small volume.

### Solution to Problem

For achieving the above object, the invention provides a cooling system which accommodates a plurality of electronic devices in a cooling bath, wherein the cooling bath defines open space of an unsealed structure provided with an inlet port and an outlet port for a liquid coolant and which directly cools the plural electronic devices by immersion of the electronic devices in the liquid coolant circulated in the open space, the cooling system having a structure wherein the liquid coolant contains a perfluorinated compound as a main component thereof and has a liquid weight loss percentage of 1.5 % or less as determined by allowing 10 ml of the liquid coolant in a 10-ml measuring cylinder (opening diameter: 11.5 mm) to spontaneously evaporate under normal environment at a room temperature of 25 °C for 100 hours.

According to a preferred aspect of the invention, the cooling system may have an arrangement wherein the liquid coolant has a steam pressure of 1.0 kPa or less at room temperature of 25 °C.

According to a preferred aspect of the invention, the cooling system may have an arrangement wherein the liquid coolant has a boiling point of 150 °C or more.

According to a preferred aspect of the invention, the cooling system may have an arrangement wherein the perfluorinated compound as the main component is a perfluorinated compound having a carbon number of 10 or more.

According to a preferred aspect of the invention, the cooling system may have a structure wherein a header connected to the inlet port and extended in a width direction of the cooling bath is disposed at a bottom of the cooling bath and is configured to be supplied with the liquid coolant via the inlet port and to eject the liquid coolant from a plurality of nozzles arranged thereon in arrays.

According to a preferred aspect of the invention, the cooling system may have a structure wherein the plural nozzles consist of a plurality of nozzle groups arranged in a longitudinal direction of the header with required spacing, and each of the nozzle groups consists of nozzles with ejection orifices radially dispersed.

According to a preferred aspect of the invention, the cooling system may have a structure wherein each of the plural nozzle groups corresponds to each of the plural electronic devices.

According to a preferred aspect of the invention, the cooling system may have a structure wherein the outlet port and the inlet port are interconnected via a flow passage, while at least one pump for moving the liquid coolant and one heat exchanger for cooling the liquid coolant are disposed in the flow passage. Advantageous Effects of Invention

According to the inventive cooling system, the perfluorinated compound has excellent features which include: high electric insulating property; high heat transfer capacity; inertness or high thermal and chemical stability; incombustibility; an ozone depleting potential of zero because of being an oxygen-free compound; and the like. If the liquid coolant containing such a perfluorinated compound as the main component exhibits a liquid weight loss percentage of 1.5 % or less as determined by allowing 10 ml of the liquid coolant in a 10-ml measuring cylinder (opening diameter: 11.5 mm) to spontaneously evaporate under normal environment at a room temperature of 25 °C for 100 hours, the liquid coolant is less prone to evaporation even in a case where the cooling bath defines an open space of an unsealed structure. Thus, the cooling system can notably reduce the evaporative loss of the liquid coolant. Since the cooling system is adapted to eliminate a potential fear of local boiling of the liquid coolant in the cooling bath, the high heat transfer capacity of the perfluorinated compound is not impaired by the boiling liquid coolant. Therefore, the cooling system can achieve the efficient cooling of the plural electronic devices densely accommodated in the cooling bath of a small volume.

According to preferred embodiments of the invention, the cooling system is similarly adapted to decrease the evaporation of the liquid coolant even though the cooling bath defines the open space of an unsealed structure, thus achieving a notable reduction of the evaporative loss of the liquid coolant in the case where the liquid coolant has a steam pressure of 1.0 kPa or less at room temperature of 25 °C, where the liquid coolant has a boiling point of 150 °C or more, or where the perfluorinated compound as the main component is a perfluorinated compound having a carbon number of 10 or more. In addition, the cooling system can eliminate the potential fear of local boiling of the liquid coolant in the cooling bath. While the cooling systems employing the conventional fluorinated compounds have encountered the following problems, the invention can solve every one of them.
(1) The boiling of the fluorinated compound involves a potential risk of generating an extremely harmful fluorinated compound such as hydrogen fluoride by reaction with trace amounts of ambient hydrogen or oxygen.
(2) Even though immersed in an inert liquid, some of the electronic devices operating at extremely high speeds have potential to be locally raised to high temperatures, encountering the boiling of a fluorocarbon compound.
(3) In the event of loss or decline of the cooling function due to a trouble of the cooling system, the liquid coolant may be raised in temperature beyond a design limit, resulting in the boiling of the fluorocarbon compound.
(4) In the case of dropout of some component of the electronic device or chassis in the cooling bath or the case of invasion of some external foreign substance into the cooling bath of an open structure, the liquid temperature of the cooling bath may be locally raised due to local stagnation of liquid circulation, resulting in the boiling of the fluorocarbon compound.

According to the preferred embodiment of the invention, the cooling system has the structure wherein the header connected to the inlet port and extended in the width direction of the cooling bath is disposed at the bottom of the cooling bath and is configured to be supplied with the liquid coolant via the inlet port and to eject the liquid coolant from the plurality of nozzles arranged thereon in arrays. In this case, the cooling system is adapted to circulate a cold liquid coolant throughout the whole space of the cooling bath, further enhancing the effect of direct cooling based on forced circulation of the liquid coolant.

According to the preferred embodiment of the invention, the cooling system has the structure wherein the plural nozzles consist of a plurality of nozzle groups arranged in the longitudinal direction of the header with required spacing, and each of the nozzle groups consists of nozzles with ejection orifices radially dispersed. In this case, the cooling system is adapted to more efficiently circulate the cold liquid coolant throughout the whole space of the cooling bath, even further enhancing the effect of direct cooling based on the forced circulation of the liquid coolant.

According to the preferred embodiment of the invention, the cooling system has the structure wherein each of the plural nozzle groups corresponds to each of the plural electronic devices. In this case, the cooling system is adapted to deliver uniform cooling performance for the individual electronic devices which are densely accommodated in the cooling bath.

According to the preferred embodiment of the invention, the cooling system has the structure wherein the outlet port and the inlet port are interconnected via the flow passage, while at least one pump for moving the liquid coolant and one heat exchanger for cooling the liquid coolant are disposed in the flow passage. In this case, the cooling system is adapted for continuous and stable operation by forming the flow passage where the liquid coolant discharged from the outlet port of the cooling bath is cooled by the heat exchanger and the cold liquid coolant is supplied to the inlet port of the cooling bath.

The object and advantages of the above invention and the other object and advantages thereof will be more clearly understood by way of the following description of the embodiments. It is noted, however, that the embodiments to be described as below are intended for purpose of illustration only and are not intended to limit the scope of the invention.

### Brief Description of Drawings

Figure 1 is a longitudinal sectional view of a cooling system according to an embodiment of the invention;
Figure 2 is a transverse sectional view of the cooling system according to the embodiment of the invention;
Figure 3 is a graph showing measurement results of weight loss percentages of different liquid coolants;
Figure 4 is a table of comparison of characteristic values of perfluorinated compounds; and
Figure 5 is a schematic diagram showing a cooling system where a drive system and a coolant system are disposed in a flow passage interconnecting an outlet port and an inlet port of a cooling bath.

### Description of Embodiments

A cooling system according to a preferred embodiment of the invention will hereinbelow be described in detail with reference to the accompanying drawings. The description of the embodiment is made on an example where 8 units of electronic devices in total are densely accommodated in a cooling bath. One unit of electronic device has a structure where 4 processor boards are arranged on one surface thereof, the processor board mounted with a plurality of processors. This example is intended for illustrative purpose and the number of processors per board or the type of the processor is arbitrary. Further, the number of electronic device units is arbitrary as long as two or more electronic device units are accommodated. Such number and type do not limit the configuration of the electronic device according to the invention.

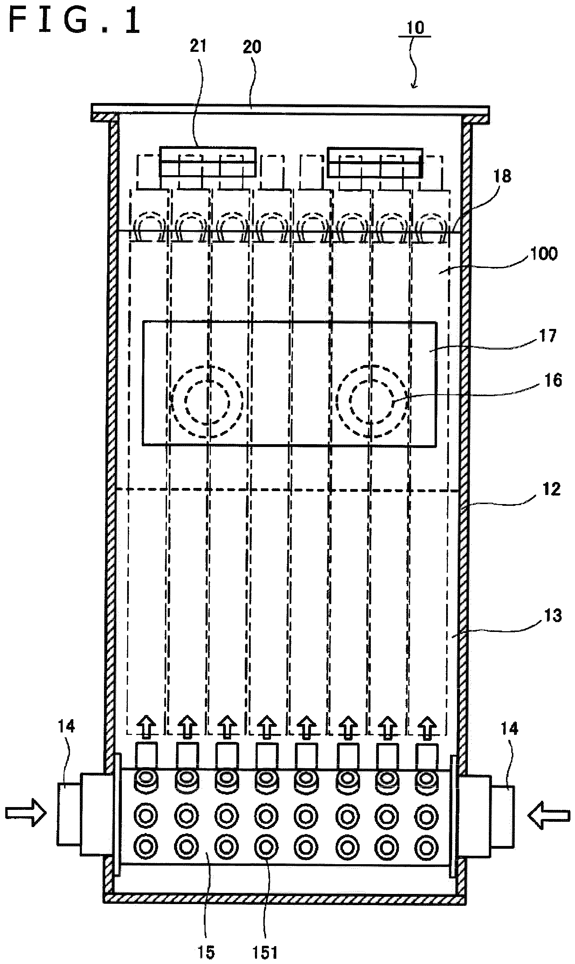

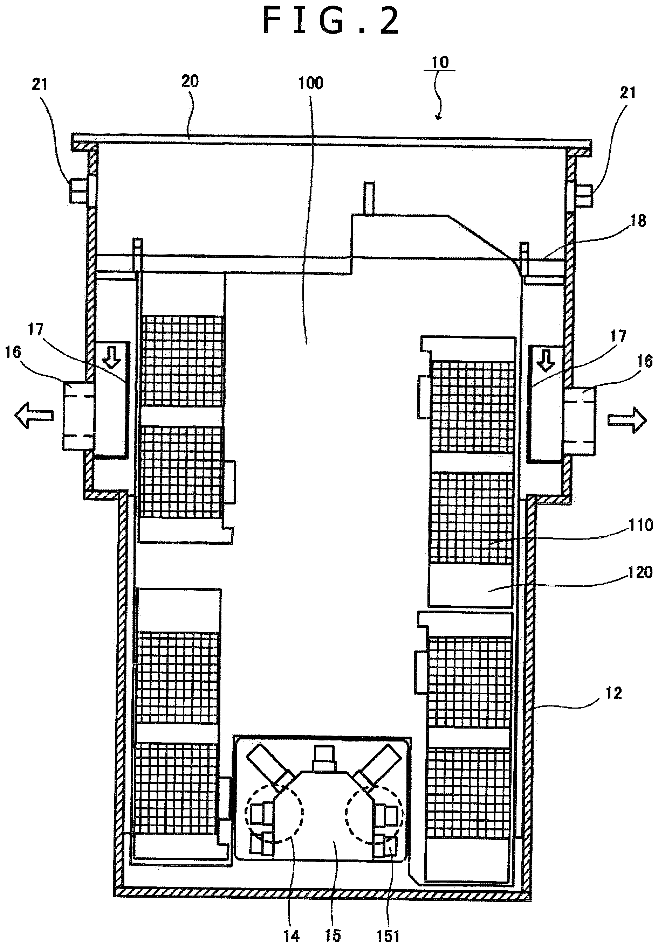

Referring to Figure 1 and Figure 2, a cooling system 10 includes a cooling bath 12. The cooling bath 12 is provided with two inlet ports 14 at each of a left-side bottom and a right-side bottom thereof and further provided with two outlet ports 16 at each place on a front side and a back side thereof. An open space in the cooling bath 12 accommodates 8 units of electronic devices 100 in total. The cooling bath 12 is configured to directly cool these electronic devices 100 by immersing these electronic devices in a liquid coolant 13 flowing in the open space. It is important to keep a liquid level 18 of the liquid coolant 13 high enough to ensure that all the heat generating components and parts of the electronic device 100 are immersed in the liquid coolant 13. According to the invention, the liquid level 18 is kept high for a long period of time because the liquid coolant 13 employed by the invention has a property of being very hard to evaporate as will be described hereinlater. In order to facilitate the maintenance work for the electronic device 100, a top board 20 is openably supported by means of an unillustrated hinge portion mounted to one edge of an upper opening of the cooling bath 12. Thus, the cooling bath 12 defines an open space of an unsealed structure. A variety of cables connected to the electronic device 100 can be drawn out from the cooling bath 12 as held together by a cable clamp 21.

A header 15 extended in a width direction (crosswise direction) of the cooling bath is disposed on a bottom of the cooling bath 12. One end of the header 15 is connected to the two inlet ports 14 at the left-side bottom of the cooling bath 12, while the other end of the header 15 is connected to the two inlet ports 14 at the right-side bottom of the cooling bath 12. The header includes a plurality of nozzles 151 arranged in arrays. The header is configured to eject the liquid coolant 13, as supplied through the right and left inlet ports 14, from these nozzles 151.

The nozzles 151 include plural nozzle groups arranged with required spacing in a longitudinal direction (crosswise direction) of the header 15. Each of the nozzle groups consists of the nozzles 151 arranged in a manner that their ejection orifices are radially dispersed on a surface of the header 15 having a hexagonal cross section.

On the cooling bath-12 side of the outlet ports 16 disposed in pairs on the front side and the back side of the cooling bath 12, a liquid guide plate 17 defines a region in a manner to cover the entire outlet ports 16 but forms an opening at an upper portion of the region. Therefore, the liquid coolant 13 flows from the upper opening toward the outlet ports 16.

The liquid coolant 13 used in the cooling system 10 consists primarily of a perfluorinated compound which has: high electric insulating property; high heat transfer capacity; inertness; high thermal and chemical stability; incombustibility; and an ozone depleting potential of zero. The liquid coolant 13 may be a single perfluorinated compound or a mixture of different perfluorinated compounds. It is important that the liquid coolant 13 has a liquid weight loss percentage of 1.5 % or less. The liquid weight loss percentage is determined by: allowing 10 ml of liquid in a 10-ml measuring cylinder (opening diameter: 11.5 mm) to spontaneously evaporate under normal environment at a room temperature of 25 °C and calculating the weight loss percentage after a lapse of 100 hours.

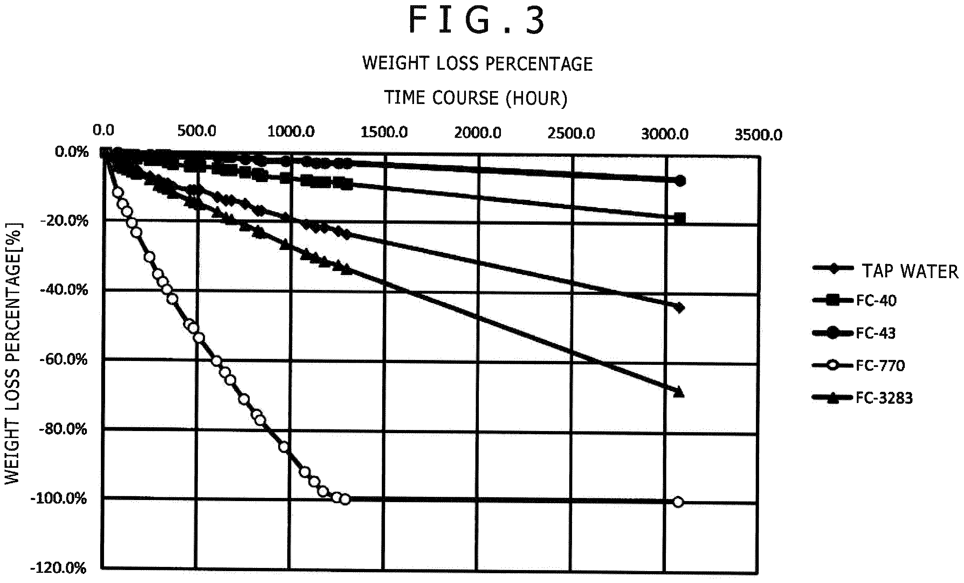

Figure 3 shows a relation between the liquid weight loss percentage and the time course in an experiment where 10 ml of each of four types of perfluorinated compounds and tap water was put in the 10-ml measuring cylinder (opening diameter: 11.5 mm) and was allowed to spontaneously evaporate under the normal environment at room temperature of 25 °C.

FC-40 denotes Fluorinert FC-40 (trade mark of 3M Limited.) commercially available from 3M Limited. Likewise, FC-43 denotes Fluorinert FC-43 commercially available from 3M Limited; FC-328 denoting Fluorinert FC-328 commercially available from 3M Limited; and FC-770 denoting Fluorinert FC-770 commercially available from 3M Limited. All these liquids are fluorine inert liquids based on a perfluorinated compound (perfluorocarbon compound), respectively. It is apparent from the gradient of weight loss percentage of FC-40 that FC-40 is much less prone to evaporation than tap water. It is also apparent that FC-43 is much less prone to evaporation than FC-40.

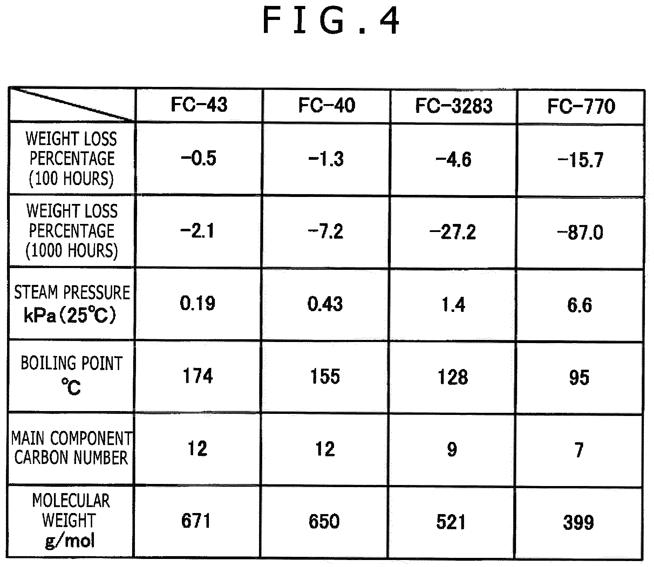

Figure 4 is a table showing the results of comparison of FC-43, FC-40, FC-3283 and FC-770 in terms of weight loss percentage after a lapse of 100 hours, weight loss percentage after a lapse of 1000 hours, steam pressure, boiling point, carbon number of main component, and molecular weight.

It is experimentally found that a liquid coolant having a weight loss percentage of 1.5 % or less after a lapse of 100 hours is less prone to evaporation even in a case where the cooling bath defines an unsealed open space. As suggested by the embodiment, it is important for the cooling bath 12 to adopt the unsealed structure such that the maintainability of the electronic devices is not impaired. It is found that the evaporative loss of the liquid coolant 13 can be notably reduced by employing FC-43 or FC-40.

It is also found that local boiling of the liquid coolant 13 on the surface of the processor 110 in the cooling bath 12, for example, can be effectively avoided by employing FC-43 or FC-40, as the liquid coolant, which has the weight loss percentage of 1.5% or less after a lapse of 100 hours. FC-43 and FC-40 afford a great advantage that the high heat transfer capacity of the perfluorinated compound is not impaired by boiling of the liquid coolant 13.

When the liquid coolant 13 has a steam pressure of 1.0 kPa at room temperature of 25 °C, when the boiling point of the liquid coolant is 150 °C or more, or when the perfluorinated compound as the main component is a perfluorinated compound having a carbon number 10 or more, the liquid coolant 13 is also less prone to evaporation even in the case where the cooling bath defines the unsealed open space. Thus, the evaporative loss of the liquid coolant 13 can be notably reduced. Further, a potential fear of local boiling of the liquid coolant on the surface of the processor 110 in the cooling bath 12, for example, can be eliminated.

Next, the advantage of providing the header 15 in the cooling system 10 according to an embodiment of the invention is described with reference to Figure 1 and Figure 2.

The header 15 is configured to eject the liquid coolant 13, as fed through the inlet ports 14, from the plural nozzles 151 arranged in arrays on the header 15. Therefore, the header 15 can circulate the cold liquid coolant 13 (cooled by a heat exchanger, as will be described hereinlater) throughout the whole space of the cooling bath 12. Thus, the effect of direct cooling of the electronic devices 100 based on the forced circulation of the liquid coolant can be enhanced.

In addition, each of the nozzle groups longitudinally arranged on the header 15 with the required spacing consists of the nozzles 151, the ejection orifices of which are radially dispersed. Hence, the header is adapted to more efficiently circulate the cold liquid coolant 13 throughout the whole space of the cooling bath 12. Particularly as shown in Figure 1 and Figure 2, each of the plural nozzle groups corresponds to each of the plural electronic devices 100. Therefore, if the electronic devices 100 are densely accommodated in the cooling bath 12, the cooling system can deliver uniform cooling performance for each of electronic devices 100.

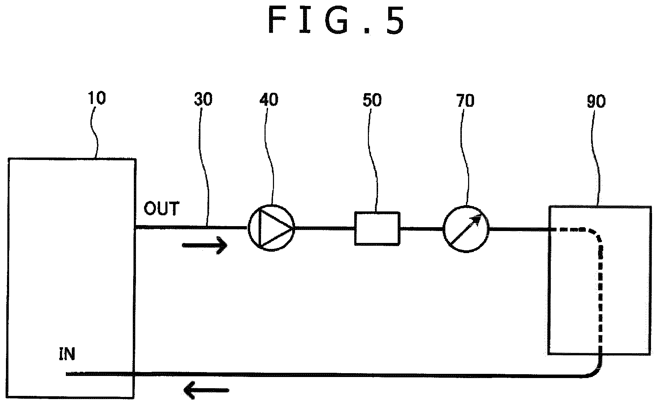

Lastly referring to Figure 5, description is made on an example of configuration a flow passage where the liquid coolant discharged from the outlet ports of the cooling bath is cooled by the heat exchanger and then, the cold liquid coolant is supplied to the inlet ports of the cooling bath. As shown in the figure, the outlet ports 16 and the inlet ports 14of the cooling bath 12 are interconnected by a flow passage 30, in which a pump 40 for moving the liquid coolant 13 and a heat exchanger 90 for cooling the liquid coolant 13 are disposed. A flow regulating valve 50 for regulating the flow rate of the liquid coolant 13 through the flow passage 30 and a flowmeter 70 are also disposed in the flow passage 30.

The pump 40 may preferably have a capability of moving a liquid having a relatively high kinetic viscosity (above 3 cSt at room temperature of 25 °C). This is because the kinetic viscosity of FC-43 is in the range of 2.5 to 2.8 cSt while that of FC-40 is in the range of 1.8 to 2.2 cSt. The flow regulating valve 50 may be a manually operable type or may be equipped with an adjustment mechanism for keeping a constant flow rate based on the measurement value determined by the flowmeter 70. Further, the heat exchanger 90 may be any of a variety of circulating heat exchangers (radiators or chillers) or coolers.

The cooling system 10 of the embodiment may further include: a first liquid temperature sensor (not shown) in the cooling bath 12 or the flow passage 30; and a mechanism (not shown) which is adapted to deactivate the electronic devices 100 or to power down the electronic devices 100 when the first temperature sensor detects a temperature exceeding a predetermined level. The addition of such a fail-safe mechanism can obviate the occurrence of abnormal temperature rise of the liquid coolant 13 above the set temperature and prevent the breakage of the electronic device and the generation of a harmful compound from fluorocarbon.

Further, the fail-safe mechanism may have another configuration. The cooling system of the embodiment may also include: a second temperature sensor (not shown) disposed in the electronic devices 100 immersed in the cooling bath 12 or around the electronic devices 100 immersed in the cooling bath 12; and the mechanism (not shown) which is adapted to deactivate the electronic devices 100 or to power down the electronic devices 100 when the first temperature sensor detects a temperature exceeding a predetermined level.

According to the invention, the processor is illustrated as the electronic device 100. The processor may include either of or both of CPU and GPU and may further include unillustrated high-speed memory, chip set, network unit, PCI Express bus, bus switch unit, SSD, and power unit. The electronic device 100 may be a server including a blade server, rooter, memory device such as SSD.

### Industrial Applicability

The invention is applicable to a wide variety of cooling systems for efficiently cooling a plurality of electronic devices densely accommodated in the cooling bath of a small volume. Reference Signs List

- 10:: cooling system
- 12:: cooling bath
- 13:: liquid coolant
- 14:: inlet port
- 15:: header
- 151:: nozzle
- 16:: outlet port
- 17:: liquid guide plate
- 18:: liquid level
- 20:: top board
- 21:: cable clamp
- 30:: flow passage
- 40:: pump
- 50:: flow regulating valve
- 70:: flowmeter
- 90:: heat exchanger
- 100:: electronic device
- 110:: processor (with radiator)
- 120:: processor board

## Claims

1. A cooling system (10) which accommodates a plurality of electronic devices (100) in a cooling bath (12), wherein the cooling bath (12) defines an open space of an unsealed structure provided with an inlet port (14) and an outlet port (16) for a liquid coolant (13) and which directly cools the plural electronic devices (100) by immersion of the electronic devices (100) in the liquid coolant (13) circulated in the open space, **characterized in that** the liquid coolant (13) contains a perfluorinated compound as a main component thereof and has a liquid weight loss percentage of 1.5 % or less as determined by allowing 10 ml of the liquid coolant (13) in a 10-mlmeasuring cylinder (opening diameter: 11.5 mm) to spontaneously evaporate under normal environment at a room temperature of 25 °C for 100 hours.

2. The cooling system (10) according to Claim 1, wherein the liquid coolant (13) has a steam pressure of 1.0 kPa or less at room temperature of 25 °C.

3. The cooling system (10) according to Claim 1 or 2, wherein the liquid coolant (13) has a boiling point of 150 °C or more.

4. The cooling system (10) according to any one of Claims 1 to 3, wherein
the perfluorinated compound as the main component is a perfluorinated compound having a carbon number of 10 or more.

5. The cooling system (10) according to any one of Claims 1 to 4, wherein
a header (15) connected to the inlet port (14) and extended in a width direction of the cooling bath (12) is disposed at a bottom of the cooling bath (12) and is configured to be supplied with the liquid coolant (13) via the inlet port (14) and to eject the liquid coolant (13) from a plurality of nozzles (151) arranged thereon in arrays.

6. The cooling system (10) according to Claim 5, wherein
the plural nozzles (151) consist of a plurality of nozzle groups arranged in a longitudinal direction of the header (15) with required spacing, and each of the nozzle groups consists of nozzles (151) with ejection orifices radially dispersed.

7. The cooling system (10) according to Claim 6, wherein
each of the plural nozzle groups corresponds to each of the plural electronic devices.

8. The cooling system (10) according to any one of Claims 1 to 7, wherein
the outlet port (16) and the inlet port (14) are interconnected via a flow passage (30), while at least one pump (40) for moving the liquid coolant (13) and one heat exchanger (90) for cooling the liquid coolant (13) are disposed in the flow passage (30).

9. The cooling system (10) according to any one of Claims 1 to 8, further comprising:
a first liquid temperature sensor disposed in the cooling bath (12) or the flow passage (30); and a mechanism which deactivates the electronic devices (100) or power downs the electronic devices (100) in a case where the first temperature sensor detects a temperature higher than a predetermined level.

10. The cooling system (10) according to any one of Claims 1 to 8, further comprising: a second temperature sensor disposed in the electronic devices (100) immersed in the cooling bath (12) or disposed around the electronic devices (100) immersed in the cooling bath (12); and a mechanism which deactivates the electronic devices (100) or power downs the electronic devices (100) in a case where the second temperature sensor detects a temperature higher than a predetermined level.

## Patentansprüche

1. Kühlsystem (10), das eine Vielzahl von elektronischen Einrichtungen (100) in einem Kühlbad (12) aufnimmt, wobei das Kühlbad (12) einen offenen Raum einer unversiegelten Struktur, die mit einer Einlassöffnung (14) und einer Auslassöffnung (16) für ein flüssiges Kühlmittel (13) versehen ist, definiert und die Vielzahl von elektronischen Einrichtungen (100) durch Eintauchen der elektronischen Einrichtungen (100) in das im offenen Raum zirkulierende flüssige Kühlmittel (13) direkt kühlt, **dadurch gekennzeichnet, dass**
das flüssige Kühlmittel (13) eine perfluorierte Verbindung als eine Hauptkomponente davon enthält und einen Flüssigkeitsgewichtsverlustprozentsatz von 1,5 % oder weniger aufweist, der bestimmt ist durch spontanes Verdampfen lassen von 10 ml des flüssigen Kühlmittels (13) in einem 10-ml-Messzylinder (Öffnungsdurchmesser: 11,5 mm) unter Normalbedingungen bei einer Raumtemperatur von 25 °C über 100 Stunden.

2. Kühlsystem (10) nach Anspruch 1, wobei das flüssige Kühlmittel (13) einen Dampfdruck von 1,0 kPa oder weniger bei einer Raumtemperatur von 25 °C aufweist.

3. Kühlsystem (10) nach Anspruch 1 oder 2, wobei das flüssige Kühlmittel (13) einen Siedepunkt von 150 °C oder mehr aufweist.

4. Kühlsystem (10) nach einem der Ansprüche 1 bis 3, wobei
die perfluorierte Verbindung als Hauptkomponente eine perfluorierte Verbindung mit einer Kohlenstoffzahl von 10 oder mehr ist.

5. Kühlsystem (10) nach einem der Ansprüche 1 bis 4, wobei
ein mit der Einlassöffnung (14) verbundener und in Breitenrichtung des Kühlbades (12) verlängerter Kopf (15) an einem Boden des Kühlbades (12) angeordnet ist und konfiguriert ist, über die Einlassöffnung (14) mit dem flüssigen Kühlmittel (13) versorgt zu werden und das flüssige Kühlmittel (13) aus einer Vielzahl von darauf in Arrays angeordneten Düsen (151) auszustoßen.

6. Kühlsystem (10) nach Anspruch 5, wobei
die mehreren Düsen (151) aus einer Vielzahl von Düsengruppen bestehen, die in einer Längsrichtung des Kopfes (15) mit einem erforderlichen Abstand angeordnet sind, und jede der Düsengruppen aus Düsen (151) mit radial verteilten Ausstoßöffnungen besteht.

7. Kühlsystem (10) nach Anspruch 6, wobei
jede der mehreren Düsengruppen mit jeweils einer der mehreren elektronischen Vorrichtungen korrespondiert.

8. Kühlsystem (10) nach einem der Ansprüche 1 bis 7, wobei
die Auslassöffnung (16) und die Einlassöffnung (14) über einen Durchflusskanal (30) miteinander verbunden sind, während mindestens eine Pumpe (40) zum Bewegen des flüssigen Kühlmittels (13) und ein Wärmetauscher (90) zum Kühlen des flüssigen Kühlmittels (13) im Durchflusskanal (30) angeordnet sind.

9. Kühlsystem (10) nach einem der Ansprüche 1 bis 8, ferner umfassend:
einen ersten Flüssigkeitstemperatursensor, der im Kühlbad (12) oder im Durchflusskanal (30) angeordnet ist; und einen Mechanismus, der in einem Fall, in dem der erste Temperatursensor eine Temperatur erfasst, die höher als ein vorgegebenes Niveau ist, die elektronischen Vorrichtungen (100) deaktiviert oder die elektronischen Vorrichtungen (100) abschaltet.

10. Kühlsystem (10) nach einem der Ansprüche 1 bis 8, ferner umfassend: einen zweiten Temperatursensor, der in den in das Kühlbad (12) eingetauchten elektronischen Einrichtungen (100) oder um die in das Kühlbad (12) eingetauchten elektronischen Einrichtungen (100) herum angeordnet ist; und einen Mechanismus, der in einem Fall, in dem der zweite Temperatursensor eine Temperatur erfasst, die höher als ein vorgegebenes Niveau ist, die elektronischen Einrichtungen (100) deaktiviert oder die elektronischen Einrichtungen (100) abschaltet.

## Revendications

1. Système de refroidissement (10) incorporant une pluralité de dispositifs électroniques (100) dans un bain de refroidissement (12), le bain de refroidissement (12) définissant un espace ouvert d'une structure non étanche munie d'un orifice d'entrée (14) et d'un orifice de sortie (16) pour un liquide de refroidissement (13), et refroidissant directement la pluralité de dispositifs électroniques (100) par l'immersion des dispositifs électroniques (100) dans le liquide de refroidissement (13) circulant dans l'espace ouvert,
**caractérisé en ce que**
le liquide de refroidissement (13) contient un composé perfluoré, qui est son principal composant, et présentant un pourcentage de perte de poids du liquide de 1,5% ou moins, déterminé en permettant l'évaporation spontanée de 10 ml de liquide de refroidissement (13) dans une éprouvette graduée de 10 ml (diamètre d'ouverture : 11,5 ml) dans un environnement normal à une température ambiante de 25°C pendant 100 heures.

2. Système de refroidissement (10) selon la revendication 1, le liquide de refroidissement (13) possédant une pression de vapeur de 1,0 KPa ou moins à une température ambiante de 25°C.

3. Système de refroidissement (10) selon la revendication 1 ou 2, le point d'ébullition du liquide de refroidissement (13) étant 150°C ou davantage.

4. Système de refroidissement (10) selon une quelconque des revendications 1 à 3, dans lequel
le composé perfluoré en tant que principal composant est un composé perfluoré avec un indice carbone 10 ou davantage.

5. Système de refroidissement (10) selon une quelconque des revendications 1 à 4, dans lequel
un collecteur (15) raccordé à l'orifice d'entrée (14) et s'étendant dans une direction de la largeur du bain de refroidissement (12) est disposé sur un fond du bain de refroidissement (12), et est configuré pour être alimenté en liquide de refroidissement (13) par le biais de l'orifice d'entrée (14), et pour refouler le liquide de refroidissement (13) par une pluralité de buses (151) agencées sur celui-ci en réseaux.

6. Système de refroidissement (10) selon la revendication 5, dans lequel
la pluralité de buses (151) consiste en une pluralité de groupes de buses agencées dans une direction longitudinale du collecteur (15), avec un espacement spécifié, et chacun des groupes de buses étant composé de buses (151) avec des orifices d'éjection dispersés radialement.

7. Système de refroidissement (10) selon la revendication 6, chacun de la pluralité de groupes de buses correspondant à chaque dispositif de la pluralité de dispositifs électroniques.

8. Système de refroidissement (10) selon une quelconque des revendications 1 à 7, dans lequel
l'orifice de sortie (16) et l'orifice d'entrée (14) sont interconnectés par le biais d'un passage d'écoulement (30), tandis qu'au moins une pompe (40) pour le déplacement du liquide de refroidissement (13) et un échangeur de chaleur (90) pour le refroidissement du liquide de refroidissement (13) sont disposés dans le passage d'écoulement (30).

9. Système de refroidissement (10) selon une quelconque des revendications 1 à 8, comprenant en outre :
un premier capteur de température du liquide agencé dans le bain de refroidissement (12) ou le passage d'écoulement (30) ; et un mécanisme désactivant les dispositifs électroniques (100) ou mettant hors tension les dispositifs électroniques (100) dans l'éventualité où le premier capteur de refroidissement détecte une température supérieure à un niveau prédéterminé.

10. Système de refroidissement (10) selon une quelconque des revendications 1 à 8, comprenant en outre :
un deuxième capteur de température disposé dans les dispositifs électroniques (100) immergés dans le bain de refroidissement (12), ou disposés autour des dispositifs électroniques (100) immergés dans le bain de refroidissement (12) ; et un mécanisme désactivant les dispositifs électroniques (100) ou mettant hors tension les dispositifs électroniques (100) dans l'éventualité où le deuxième capteur de refroidissement détecte une température supérieure à un niveau prédéterminé.
